# EUROPEAN PATENT APPLICATION

(11) **EP 4 579 586 A1**
(43) Date of publication of application: **02.07.2025**
(21) Application number: 24207005.0
(22) Date of filing: 16.10.2024
(51) Int. Cl.: G06T 7/00

(54) **METHODS AND APPARATUS TO DETECT DEFECTS IN GATE-ALL-AROUND TRANSISTOR ARCHITECTURES**

(30) Priority: 27.12.2023 US 202318397738
(71) Applicant: INTEL Corporation, Santa Clara, CA 95054 (US)
(72) Inventor: SHARMA, Manish, Portland, 97229 (US); SANGHAVI, Shail, Portland, 97229 (US); DAS, Sanjib, North Plains, 97133 (US); PERNG, Ya-Chuan, Portland, 97229 (US); DONVALKAR, Prathamesh Surendra, Hillsboro, 97124 (US); LIN, Yu-Ting, Hillsboro, 97124 (US); BEN SALAH, Mohamed, Beaverton, 97007 (US); ABEL, Mark, Portland, 97203 (US)
(74) Representative: HGF

(57) **Abstract**

Systems, apparatus, articles of manufacture, and methods to detect defects in gate-all-around transistor architectures are disclosed. An apparatus includes interface circuitry; machine readable instructions; and programmable circuitry to at least one of instantiate or execute the machine readable instructions to: determine a first contrast to noise ratio (CNR) in a first image of a location on a semiconductor wafer; determine a second CNR in a second image of the location on the semiconductor wafer; and determine whether the location includes a buried defect based on the first CNR and the second CNR.

## Description

### FIELD OF THE DISCLOSURE

This disclosure relates generally to semiconductor device fabrication and, more particularly, to methods and apparatus to detect defects in gate-all-around transistor architectures.

### BACKGROUND

Field-effect transistors (FETs) include a gate to control the conductivity of a semiconductor material extending between a source and drain of the transistor. More particularly, when energized, the gate activates a channel to enable current to pass between the source and the drain. Some transistors are non-planar such as FinFET and gate-all-around (GAA) transistors. In FinFET technology, the gate extends around a fin-shaped semiconductor material defining the source and the drain. In GAA transistors, the gate completely surrounds a full perimeter of one or more wires or strips of semiconductor material defining the channel between the source and the drain.

### BRIEF DESCRIPTION OF THE DRAWINGS

FIG. 1 is a cross-sectional view of an example gate-all-around (GAA) transistor.
FIG. 2 illustrates another example GAA transistor similar to the transistor of FIG. 1 except for the defects in the different epitaxial fill regions.
FIG. 3 is a top view (e.g., plan view) of an example array of transistors on a semiconductor wafer captured by an inspection tool (e.g., an SEM tool) in accordance with teachings disclosed herein.
FIG. 4 is an example truth table showing the combination of contrast to noise ratio (CNR) values for SEM images generated using both high and low landing energies and the corresponding types of defects that may be determined from the combination of such CNR values.
FIG. 5 illustrates an example semiconductor inspection system that may be implemented to detect and classify defects in epitaxial fill regions of GAA transistors.
FIG. 6 is a block diagram of an example implementation of the semiconductor inspection circuitry of FIG. 5 to inspect epitaxial fill regions to identify and classify defects associated with missing epitaxial fill.
FIG. 7 is a flowchart representative of example machine readable instructions and/or example operations that may be executed, instantiated, and/or performed by example programmable circuitry to implement the semiconductor inspection circuitry of FIG. 6.
FIG. 8 is a block diagram of an example processing platform including programmable circuitry structured to execute, instantiate, and/or perform the example machine readable instructions and/or perform the example operations of FIG. 7 to implement the semiconductor inspection circuitry of FIG. 6.
FIG. 9 is a block diagram of an example implementation of the programmable circuitry of FIG. 8.
FIG. 10 is a block diagram of another example implementation of the programmable circuitry of FIG. 8.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

Processing defects in semiconductor device manufacturing coming from processing tools (wet cleans, dry etches, lithography, depositions, thin films, etc.) can be categorized as systematic and random defects. Systematic defects mainly come from process marginality. Random defects come from chamber/tool issues. Both systematic and random defects end up causing end-of-line (EOL) fails that reduce yields and, therefore, can result in delay in product deliverables. Resolving defect issues (both systematic and random) as soon as possible (e.g., at the time when the defects are initially created at the source where they occur) is important to reduce EOL failures and improve yields, thereby enabling manufacturers to meet product commitments.

Industry standards to detect defects as they occur involve the use of inline defect metrology monitors at various points in the production process flow. In some instances, these monitors use optical inspection tools (dark field inspection or bright field inspection) to capture images of a unit in production (e.g., a semiconductor die and/or a wafer of multiple dies) and then analyze the image to identify defects. Additionally or alternatively, defect metrology monitors can include voltage contrast (VC) imaging, which uses secondary electron signals to highlight differences in surface potential between good (e.g., non-defective) and bad (e.g., defective) sites on a unit in production.

Optical inspection tools generally have a higher throughput and can image or scan larger areas than is possible using VC imaging. However, optical inspection tools are limited to capturing (e.g., detecting) physical defects on the wafer surface (e.g., in direct line of sight of the inspection tool and/or within the top few nanometers of the exposed upper surface). Further, optical inspection tools are limited to detecting physical defects that produce a distinguishable optical contrast compared to the same location on the reference good (e.g., non-defective) component (e.g., semiconductor die). Optical inspection tools are also limited in the resolution that can be achieved based on the type of optical tool used and the associated parameters of its implementation (e.g., the wavelength used, whether bright or dark field optic modes are used, etc.).

VC imaging can detect certain defects in transistors that would be missed through optical inspection. However, VC imaging can only be performed after further downstream processing of an integrated circuit is completed (e.g., after metal layers have been added to provide electrical routing to electrically couple different transistors into a circuit to be tested). Thus, in many instances, defects detected by VC imaging are only detectable long after the fabrication process that gave rise to the defects.

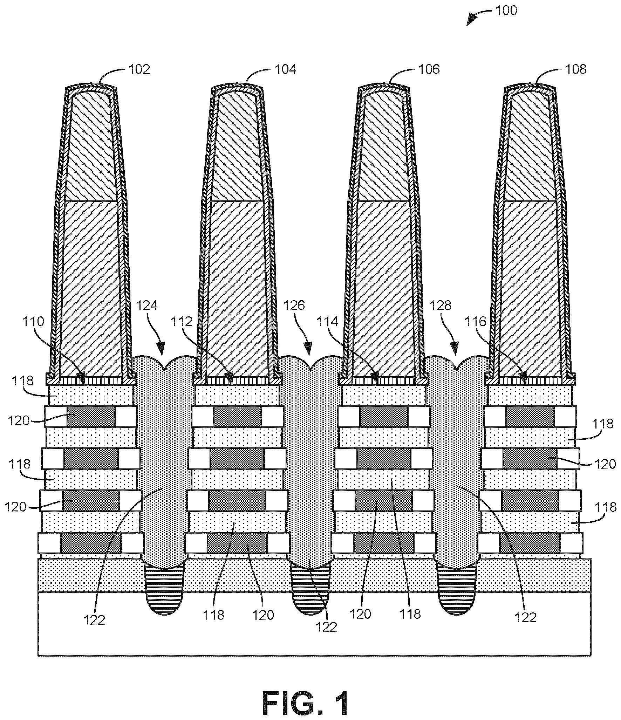

FIG. 1 is a cross-sectional view of an example gate-all-around (GAA) transistor 100. In this example, the transistor 100 includes four gates 102, 104, 106, 108 positioned above four corresponding stacks 110, 112, 114, 116 of semiconductor strips 118. In this example, the semiconductor plates 118 are silicon nano ribbons that extend into and out of the drawing. In other examples, the semiconductor strips 118 can be made from a different semiconductor material (e.g., germanium, gallium arsenide, etc.) and/or have a different shape (e.g., nanowires). In this example, the stacks 110, 112, 114, 116 each include four separate semiconductor strips 118 separated by intervening layers of dielectric material 120. In other examples, the stacks 110, 112, 114, 116 of semiconductor strips 118 can include any other suitable number of strips 118. The example semiconductor strips 118 define the channel region of the field-effect transistor between source and drain regions 124, 126, 128 located between adjacent ones of the stacks 110, 112, 114, 116 of semiconductor strips 118.

The fabrication of GAA transistors, such as the GAA transistor 100 of FIG. 1, involves the creation of the stacks 110, 112, 114, 116 of semiconductor strips 118, followed by the creation of the gates 102, 104, 106, 108 on top of the stacks 110, 112, 114, 116. After the creation of the gates 102, 104, 106, 108 is conductive material 122 added to fill in the source and drain regions 124, 126, 128. More particularly, the conductive material 122 for the source and drain regions 124, 126, 128 is epitaxially grown from the exposed sides of the semiconductor strips 118 to fill the space between adjacent ones of the stacks 110, 112, 114, 116 (e.g., to fill the source and drain regions 124, 126, 128). As shown in FIG. 1, when properly grown, the conductive material 122 fills the source and drain regions 124, 126, 128. Thus, the conductive material 122 is also referred to herein as an epitaxial fill (also referred to as EPI fill or simply EPI for short) and the source and drain regions 124, 126, 128 are also generically referred to herein as epitaxial fill regions. In some examples, the epitaxial fill 122 (e.g., the conductive material 122) is the same semiconductor material (e.g., silicon) used for the semiconductor strips 118. However, in other examples, a different material can be epitaxial grown (e.g., via heteroepitaxy) from the exposed sides of the semiconductor strips 118.

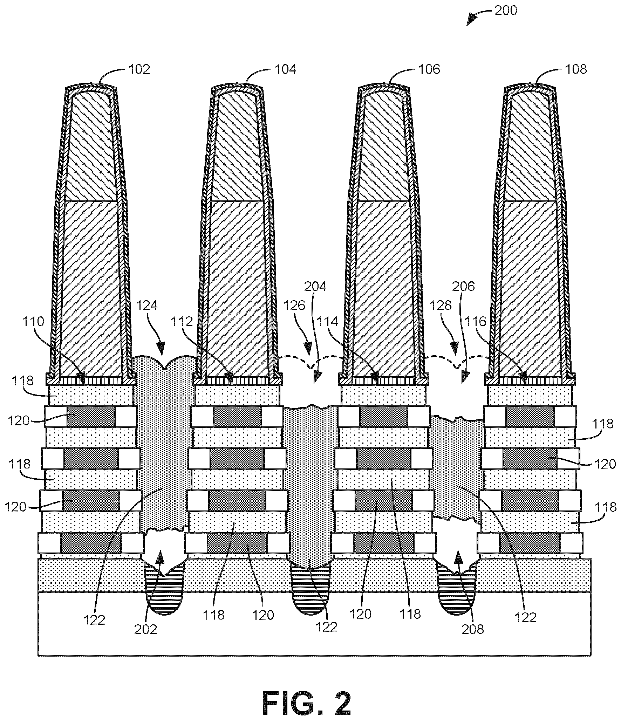

As shown in the illustrated example, the epitaxial fill regions 124, 126, 128 (e.g., the source and drain regions 124, 126, 128) are defined on both sides by the stacks 110, 112, 114, 116 of semiconductor strips 118. As a result, the epitaxial fill 122 grows from both facing sides of adjacent stacks 110, 112, 114, 116 until the epitaxial fill 122 meets in the middle and fills the entire space or gap (e.g., the epitaxial fill region 124, 126, 128) between the adjacent stacks 110, 112, 114, 116 of semiconductor strips 118. Due to process marginality and incoming process variations, the epitaxial fill 122 does not always grow uniformly within a given epitaxial fill region 124, 126, 128. As a result, it is possible for defects in the epitaxial fill region 124, 126, 128 to arise in the form of voids or areas of missing epitaxial fill 122. That is, in some situations, at least some of the epitaxial fill 122 may be missing from an epitaxial fill region 124, 126, 128 after the epitaxial growth process. Some types of potential defects in the epitaxial fill 122 are shown in the illustrated example of FIG. 2. Specifically, FIG. 2 illustrates another example GAA transistor 200 similar to the transistor 100 of FIG. 1 except for the defects in the different epitaxial fill regions 124, 126, 128.

As shown in the first epitaxial fill region 124 of FIG. 2, a first defect 202 (e.g., void, missing epitaxial fill, etc.) is located at the bottom of the first epitaxial fill region 124 with the epitaxial fill 122 extending over top of the defect 202 to cover or conceal the defect 202. That is, in this example, the epitaxial fill 122 has properly grown from the semiconductor strips 118 higher in the adjacent stacks 110, 112 but failed to properly grow from the bottom semiconductor strip 118 to fill in the bottom of the epitaxial fill region 124. Such concealed defects are referred to herein as buried defects and/or bottom defects. That is, the first defect 202 of FIG. 2 is a buried defect.

As shown in the second epitaxial fill region 126 of FIG. 2, a second defect 204 (e.g., void, missing epitaxial fill, etc.) is located at the top of the second epitaxial fill region 126 with the epitaxial fill 122 otherwise properly filling the region 126 down to the bottom. That is, in this example, the epitaxial fill 122 has properly grown from the semiconductor strips 118 lower in the adjacent stacks 112, 114 but failed to properly grow from the uppermost semiconductor strip 118 to fill in the top of the epitaxial fill region 126. As used herein, the term "top" used in the context of epitaxial fill regions refers to the portion of the regions exposed at an exterior surface to direct line of sight. That is, the "top" of an epitaxial region corresponds to the portion farthest away from the underlying base semiconductor material (e.g., wafer) on which the transistor 200 is fabricated. More particularly, the "top" portion of an epitaxial region is the portion of the region associated with the uppermost semiconductor strip 118 in the stacks 110, 112, 114, 116 and can extend down to the depth of the second uppermost semiconductor strip 118. Defects at this exposed "top" area of an epitaxial fill region are referred to herein as top defects. That is, the second defect 204 of FIG. 2 is a top defect.

As shown in the third epitaxial fill region 128 of FIG. 2, a third defect 206 (e.g., void, missing epitaxial fill, etc.) is located at the top of the region 128 (e.g., a top defect) and a fourth defect 208 (e.g., void, missing epitaxial fill, etc.) is located at the bottom of the region 126 (e.g., a buried defect). Thus, it is possible for a given epitaxial region to include both a top defect and a buried defect.

In addition to buried defects and top defects, it is possible for the epitaxial fill 122 to fail to grow at all within a given epitaxial region 124, 126, 128. In such situations, the epitaxial fill 122 would be completely missing from the epitaxial fill region 124, 126, 128 at all depths.

The different types of defects noted above (e.g., buried defects 202, 208, top defects 204, 206, and completely missing epitaxial fill) have different consequences. For instance, in the case of top missing epitaxial fill (e.g., a top defect), as well as completely missing epitaxial fill, the contact between the source and/or drain of a transistor and the subsequent metal layer will be incomplete or non-existent. As such, the transistor will not be electrically coupled to other components in the associated circuitry of a die such that the resulting device will not function properly, if at all. As such, top defects result in yield loss. By comparison, when the epitaxial material is missing near the bottom but is still present near the top (e.g., a buried defect), the transistor may still be able to function and be electrically coupled to other components in a die. As such, buried defects do not cause a first order yield impact. However, such defects may still pose some concern for reliability and, therefore, may be unsuitable for certain applications though still acceptable for others. Accordingly, there is a need to be able to identify or detect both buried defects and top defects and to be able to distinguish between the two.

While it may be possible to detect both top defects and buried defects using existing inspection tools, such tools do not provide sufficient resolution or precision to be able to distinguish top defects from buried defects. As a result, existing techniques are unable to determine whether a defect results in a yield loss (e.g., a top defect) for which the associated die must be discarded as inoperable or whether a defect is of potential concern but still usable (e.g., a buried defect). Examples disclosed herein overcome the above difficulty by combining the use of optical inspection tools with high-resolution scanning electron microscope (SEM) tools to detect locations of defects and to classify the type and/or nature of defects including whether the defects are top defect, buried defects, or defects associated with completely missing epitaxial fill.

Specifically, examples disclosed herein involve the capture of images of a semiconductor wafer or portion thereof (e.g., a semiconductor die) followed by an analysis of the contrast of different locations to identify anomalies indicative of defects. In particular, captured images are segmented to isolate pixels in the images corresponding to each epitaxial fill region 124, 126, 128 under investigation from the background and the grey level intensities of the segmented portions of the image are measured. In some examples, the grey level intensities are further processed to calculate a contrast to noise ratio (CNR) that correlates to the darkness of the epitaxial fill 122. As a result, the strength of the CNR can be used as an indicator of the presence of absence of the epitaxial fill 122. As used herein, the strength of the CNR refers to how negative the CNR is with larger negative values (e.g., stronger CNR values) indicating less epitaxial fill is present while smaller negative values (e.g., weaker CNR values) indicating more epitaxial fill. That is, a value of zero or slightly negative but near zero value (e.g., a relatively low absolute value) for the CNR (e.g., a weak CNR) indicates no epitaxial fill 122 is missing, while a larger (lower) negative value (e.g., a higher absolute value) for the CNR (e.g., a relatively strong CNR) indicates at least some epitaxial fill 122 is missing. An even larger (lower) negative values (e.g., an even higher absolute value) for the CNR (e.g., a very strong CNR) indicates the epitaxial fill 122 is completely missing. In some examples, the CNR value is normalized with respect to the background grey level to account for wafer-to-wafer variations.

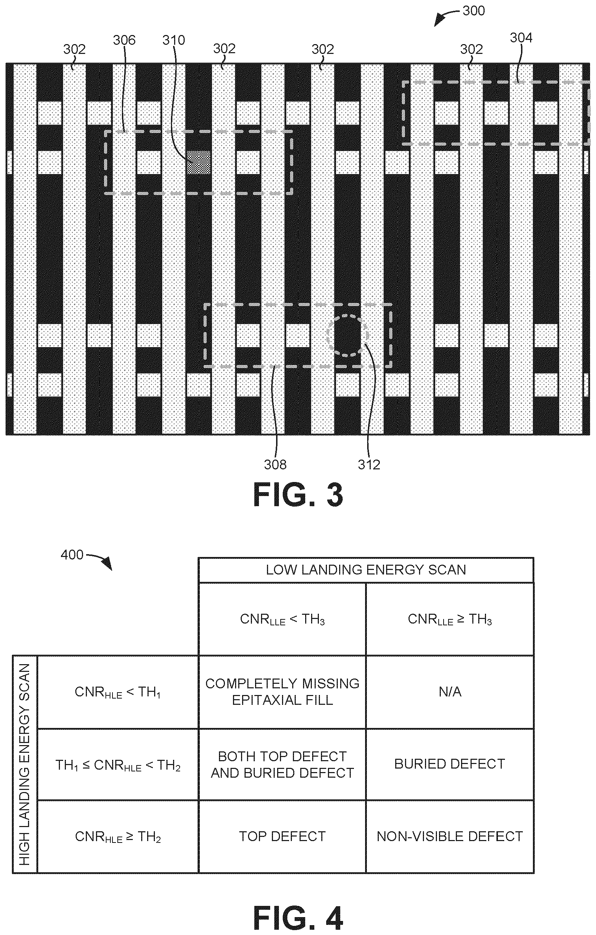

FIG. 3 illustrates an example image 300 taken from a top view (e.g., plan view) of an example array of transistors on a semiconductor wafer captured by an inspection tool (e.g., an SEM tool) in accordance with teachings disclosed herein. The example array of transistors shown in FIG. 3 correspond to an integrated circuit die implementing static random-access memory (SRAM). However, the transistors can be in any other suitable arrangement. In FIG. 3, the light colored vertical bands 302 correspond to gate structures (e.g., the gates 102, 104, 106, 108 in FIGS. 1 and 2) for different ones of the transistors in the image 300. Thus, from the perspective of the image 300 of FIG. 3, the light colored vertical bands 302 also correspond to the locations of the stacks of semiconductor strips (e.g., the strips 118 of FIGS. 1 and 2) located underneath the gate structures. For purposes of explanation, three separate transistors 304, 306, 308 are demarcated by rectangles shown in broken lines in FIG. 3. As shown, each of the transistors 304, 306, 308 extends across four gate structures (e.g., four light colored bands 302) in a similar manner to the transistors 100, 200 shown in FIG. 1 and 2. Thus, each of the transistors 304, 306, 308 demarcated in FIG. 3 includes three epitaxial fill regions (e.g., similar to the regions 124, 126, 128 of FIGS. 1 and 2) indicated by the light colored blocks between the gate structures within the respective transistors 304, 306, 308.

In the illustrated example of FIG. 3, the first transistor 304 represents a transistor that does not have any defects due to missing epitaxial fill. This is indicated by the relatively light color shown in each of the three epitaxial fill regions. That is, the CNR for each epitaxial fill region within the first transistor 304 is relatively weak (e.g., at or near zero), thereby indicating no epitaxial fill material is missing. By contrast, the central epitaxial fill region (identified by the reference numeral 310) in the second transistor 306 is a darker color. The darker color of the central epitaxial fill region 310 in the second transistor 306 is an indication of a stronger CNR (e.g., a more negative CNR or a higher absolute value for the CNR) at the location, which is an indication of at least some missing epitaxial fill. The third transistor 308 demarcated in FIG. 3 is shown with an epitaxial fill region that is completely missing all epitaxial fill material as indicated by no light coloration between the gate structure at the relevant location (demarcated by a circle 312 in FIG. 3). That is, the CNR for the epitaxial fill region demarcated by the circle 312 is very strong (e.g., is very negative or has a very high absolute value), thereby indicating the epitaxial fill is completely missing at that location.

Due to the three-dimensional nature of potential defects (e.g., top defects near the top of an epitaxial fill region or buried defects near the bottom of an epitaxial region), a single SEM image (e.g., the image 300 of FIG. 3) generated using a single electron beam energy does not provide sufficient information to distinguish between yield killing top defects and tolerable buried defects (at least tolerable for certain application(s) though potentially not acceptable for others). That is, while the epitaxial fill regions containing no defects (in the first transistor 304) and the epitaxial fill region completely missing epitaxial fill (in the third transistor 308) can be readily identified, there is no way of directly determining whether the central region 310 in the second transistor 306 is a top defect or a buried defect. If the electron beam energy (also referred to herein as the landing energy) used to generate the image 300 of FIG. 3 is tuned specifically to detect top defects, then the relatively strong CNR associated with the central region 310 in the second transistor 306 could reliably be confirmed as a top defect. However, generating SEM images using such a landing energy tuned specifically for top defects is unlikely to detect buried defects, thereby increasing the possibility of the detection of such buried defects being missed. That is, top defects can be detected using a relatively low landing energy (e.g., 1.5 kV) while a much higher landing energy (e.g. 12.5 kV) is needed to penetrate to the bottom of an epitaxial fill region to detect buried defects. However, when the landing energy of an electron beam is tuned to detect buried defects (e.g., with the higher landing energy), the beam necessarily must pass through the upper portions of the epitaxial region. As a result, top defects in the epitaxial fill region will still result in an increase in the strength of the CNR at that location. Therefore, it is difficult (if not impossible) to determine whether a relatively strong CNR based on a single SEM image generated using a single landing energy corresponds to a top defect, a buried defect, or both top and buried defects.

Examples disclosed herein overcome the above challenges by implementing multiple SEM inspections at a given location using different landing energies and then comparing the results to reliably determine the nature of any defects detected at the given location. That is, a first SEM image is generated using a relatively low landing energy (that is tuned to detect top defects). Thereafter, a second SEM image is generated using a relatively high landing energy (tuned to detect buried defects). The CNR values for a given epitaxial fill region can be compared to corresponding thresholds for each of the first and second images and then used in combination to characterize or classify the type or nature of defects at the given location.

FIG. 4 is an example truth table 400 showing the combination of CNR values for SEM images generated using both high and low landing energies and the corresponding types of defects that may be determined from the combination of such CNR values. Specifically, in table 400, the CNR value at a given location (e.g., a particular epitaxial fill region) in an SEM image generated using a high landing energy (e.g., at 12.5 kV) is designated with an "HLE" subscription (e.g., CNR_{HLE}). By contrast, the CNR value at the given location (e.g., the particular epitaxial fill region) in an SEM image generated using a low landing energy (e.g., at 1.5 kV) is designated with an "LLE" subscription (e.g., CNR_{LLE}). As discussed above, the high landing energy is tuned to detect buried defects because the higher energy enables the electron beam to penetrate deeper into the semiconductor wafer under inspection. The amount of material through which the beam passes in an epitaxial fill region 124, 126, 128 depends on how completely the region is filled with the epitaxial fill 122 (e.g., whether it is completely filled, partially missing some epitaxial fill 122, or completely missing the epitaxial fill 122). Thus, different amounts of missing epitaxial fill 122, as well as the depth at which the fill material is missing, will affect the CNR_{HLE}. Accordingly, as represented in FIG. 1, the CNR_{HLE} may be compared against multiple different thresholds associated with multiple different types of defects. Further, as discussed above, the low landing energy is tuned to detect top defects because the electron beam does not need to penetrate deep into the semiconductor wafer under inspection. Accordingly, either the epitaxial fill 122 is present at the top surface of an associated region 124, 126, 128, in which case the electron beam will hit it immediately, or the epitaxial fill 122 is missing (e.g., a top defect), in which case the electron beam will travel farther than expected thereby resulting in a different value for the CNR_{LLE}. Thus, in some examples, the CNR_{LLE} is only compared against one threshold to determine whether a top defect is present or not.

More particularly, when the CNR_{HLE} is strong enough (e.g., has a high enough absolute value) to satisfy first threshold (TH₁) (e.g., is lower than the first threshold assuming negative values for the CNR_{HLE} are used), this is an indication the electron beam did not have to penetrate through any material and, therefore, indicates the epitaxial fill is completely missing. In this situation, it may not be necessary to consider the CNR_{LLE} (though it is likely to also be very negative (e.g., have a high absolute value)). When the CNR_{HLE} is not as strong but still sufficiently strong to satisfy a second threshold (TH₂) (e.g., greater than or equal to the first threshold but lower than the second threshold assuming negative values for the CNR_{HLE} are used), this is an indication the electron beam had to pass through some epitaxial fill 122 but less than all that would be expected if the corresponding region 124, 126, 128 were completely filled. While such a value for the CNR_{HLE} is an indication that there is a buried defect (because the landing energy is specifically tuned to buried defects), this cannot indicate whether or not there is also a top defect at the given region 124, 126, 128. Accordingly, when the CNR_{HLE} is between the first and second thresholds, the value of the CNR_{LLE} is also considered relative to a corresponding third threshold (TH₃). If the CNR_{LLE} satisfies the third threshold (e.g., is lower than the third threshold assuming negative values for the CNR_{LLE} are used), this indicates there is a top defect. Therefore, in this situation, the location under inspection can be classified as including both a top defect and a buried defect. If, on the other hand, the CNR_{LLE} does not satisfy the third threshold (e.g., is greater than or equal to the third threshold assuming negative values for the CNR_{LLE} are used), this is an indication there is no top defect. In this situation, the location under inspection can be classified as including only a buried defect.

Finally, when the CNR_{HLE} does not satisfy the second threshold (e.g., is greater than or equal to the second threshold assuming negative values for the CNR_{HLE} are used), this is an indication that no defect has been detected. However, as discussed above, the landing energy of the electron beam is tuned to detect buried defects and, therefore, may not detect a top defect (particularly if the top defect is relatively small). Accordingly, when the CNR_{HLE} exceeds the second threshold (e.g., is closer to zero than the second threshold though potentially still negative), the value of the CNR_{LLE} is again considered relative to the third threshold. If the CNR_{LLE} satisfies the third threshold (e.g., is lower than the third threshold assuming negative values for the CNR_{LLE} are used), this indicates there is a top defect. Therefore, in this situation, the location under inspection can be classified as including only a top defect. If, on the other hand, the CNR_{LLE} does not satisfy the third threshold (e.g., is greater than or equal to the third threshold assuming negative values for the CNR_{LLE} are used, this is an indication there is no top defect. In this situation, in which neither the CNR_{HLE} nor the CNR_{LLE} have values indicative of a defect, the location under inspection can be classified as including a non-visible defect (and/or an indication of a false positive identification of the presence of a defect).

In some examples, the first, and second thresholds against which the CNR_{HLE} is compared, as well as the third threshold against which the CNR_{LLE} is compared, can be any suitable values and set based on the CNR values at known good sites and/or known defective sites of each type noted in the table 400 of FIG. 4. As noted above, CNR values are negative. Therefore, the thresholds are also negative. However, in some examples, it may be possible to use the absolute value of the CNR measurements such that positive thresholds are used. Thus, whether a CNR "satisfies" a threshold depends on whether a negative or positive sign is used and on the direction of values defined as satisfying or not satisfying a given threshold (e.g., whether a threshold is satisfied by higher values or lower values). As outlined in the above example, a threshold is satisfied when the CNR is farther away from zero than the threshold (e.g., less than a negative threshold or the absolute value is higher than the absolute value of the threshold). In other examples, a threshold is satisfied when the CNR is closer to zero than the threshold (e.g., greater than a negative threshold or the absolute value is less than the absolute value of the threshold). Further, in the above example, a threshold is not considered to be satisfied when the CNR equals the threshold. However, in other examples, a threshold can be treated as satisfied when the CNR equals the threshold. Generally speaking, the absolute value of the first threshold is greater than the absolute value of the second threshold. In some examples, the second threshold is zero. That is, in some examples, assuming negative values are used, any non-zero and negative value for the CNR_{HLE} is an indication of at least some missing epitaxial fill 122. In other examples, the absolute value of the second threshold is greater than zero (or less than zero assuming negative values, rather than absolute values, are used).

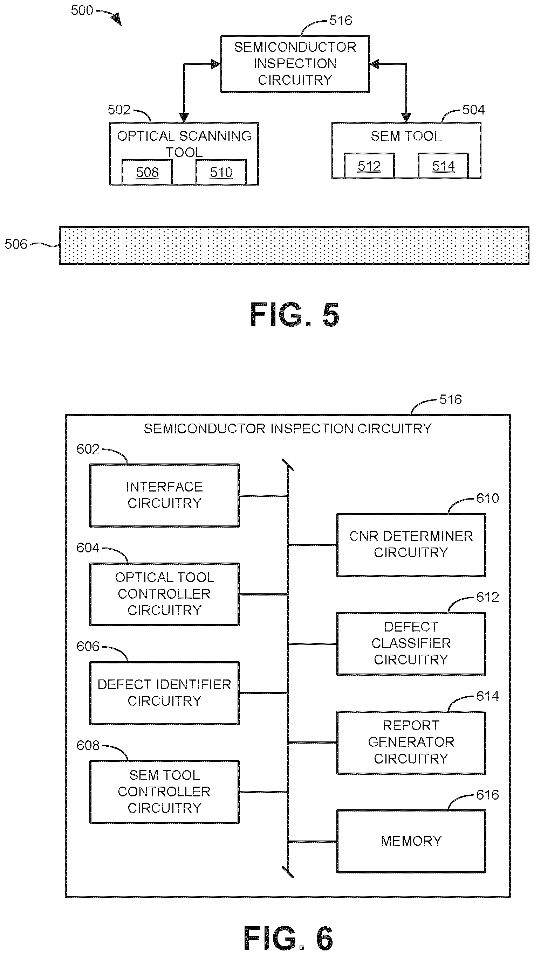

FIG. 5 illustrates an example semiconductor inspection system 500 that may be implemented to detect and classify defects in epitaxial fill regions 124, 126, 128 of GAA transistors 100, 200. As shown in the illustrated example, the semiconductor inspection system 500 includes an optical scanning tool 502 and an SEM tool 504 that are to capture scans or images of a substrate 506. In this example, the substrate 506 is a semiconductor wafer including GAA transistors (e.g., the transistors 100, 200 of FIGS. 1 and/or 2). Although the optical scanning tool 502 and the SEM tool 504 are shown side-by-side above the substrate 506, the tools 502, 504 can be separately located and implemented independent of one another at different times. That is, in some examples, the substrate 506 moves between the optical scanning tool 502 and the SEM tool 504 to enable the inspections associated with each tool.

In this example, the optical scanning tool 502 includes one or more light source(s) 508 that shine light onto the substrate 506. In some examples, the light is produced at a specific wavelength. In some examples, the light is in the visible spectrum. In some examples, the light is ultraviolet light. In this example, the optical scanning tool 502 further includes one or more sensors 510 (e.g., cameras) to capture light that is reflected and/or refracted off the substrate 506. In this way, the optical scanning tool 502 is able to generate a scan or image of the substrate 506. In some examples, the optical scanning tool 502 is implemented in a bright field inspection mode. In some examples, the optical scanning tool 502 is implemented in a dark field inspection mode. In some examples, the optical scanning tool 502 is configured so that strong signal to noise ratios (corresponding to strong contrast to noise ratios) are produced when epitaxial fill material is missing.

In the illustrated example of FIG. 5, the SEM tool 504 includes one or more electron beam generator(s) 512 to generate an electron beam that is directed towards the substrate 506. In some examples, the SEM tool 504 can adjust the landing energy of the electron beam. When the surface (and the first few nanometers under the surface) of the substrate 506 are to be imaged or scanned, the landing energy is set relatively low (e.g., 1.5 kV). When areas deeper below the surface of the substrate 506 are to be imaged or scanned (e.g., the bottom of the epitaxial fill regions 124, 126, 128 of the transistors 100, 200), the landing energy is set relatively high (e.g., 12.5 kV). In this example, the SEM tool 504 includes one or more sensors 514 (e.g., electron detectors) to detect electrons produced by the electron beam coming into contact with the substrate 506. More particularly, in some examples, the sensors 514 include a backscatter electron detector and a secondary electron detector. In some examples, the backscatter electron detector is used to detect primary backscattered electrons when the relatively high landing energy is employed, and the secondary electron detector is used to detect secondary electrons when the relatively low landing energy is employed. Based on the electrons detected by the sensors 514, the SEM tool 504 is able to generate SEM images of the locations being scanned.

As shown in this example, both the optical scanning tool 502 and the SEM tool 504 are in communication with semiconductor inspection circuitry 516. In this example, the semiconductor inspection circuitry 516 controls and/or directs operation of the scanning optical tool 502 and the SEM tool 504. Further, in this example, the semiconductor inspection circuitry 516 obtains and analyzes outputs of the optical scanning tool 502 and the SEM tool 504 (e.g., optical images and SEM images) to detect defects in in the substrate and determine the type and/or nature of such defects. More particularly, the semiconductor inspection circuitry 516 determines whether the defects are top defects, buried defects, and/or defects associated with completely missing epitaxial fill. Further detail regarding the implementation of the example semiconductor inspection circuitry 516 is provided below in connection with FIG. 6. In the illustrated example, the semiconductor inspection circuitry 516 is shown as being independent and external to the tools 502, 504. However, in other examples, some or all of the semiconductor inspection circuitry 516 can be implemented in or by the optical scanning tool 502 and/or the SEM tool 504.

FIG. 6 is a block diagram of an example implementation of semiconductor inspection circuitry 516 of FIG. 5 to inspect epitaxial fill regions 124, 126, 128 to identify and classify defects associated with missing epitaxial fill 122. The semiconductor inspection circuitry 516 of FIG. 6 may be instantiated (e.g., creating an instance of, bring into being for any length of time, materialize, implement, etc.) by programmable circuitry such as a Central Processor Unit (CPU) executing first instructions. Additionally or alternatively, the semiconductor inspection circuitry 516 of FIG. 6 may be instantiated (e.g., creating an instance of, bring into being for any length of time, materialize, implement, etc.) by (i) an Application Specific Integrated Circuit (ASIC) and/or (ii) a Field Programmable Gate Array (FPGA) structured and/or configured in response to execution of second instructions to perform operations corresponding to the first instructions. It should be understood that some or all of the circuitry of FIG. 6 may, thus, be instantiated at the same or different times. Some or all of the circuitry of FIG. 6 may be instantiated, for example, in one or more threads executing concurrently on hardware and/or in series on hardware. Moreover, in some examples, some or all of the circuitry of FIG. 6 may be implemented by microprocessor circuitry executing instructions and/or FPGA circuitry performing operations to implement one or more virtual machines and/or containers.

As shown in FIG. 6, the example semiconductor inspection circuitry 516 includes example interface circuitry 602, example optical tool controller circuitry 604, example defect identifier circuitry 606, example SEM tool controller circuitry 608, example CNR determiner circuitry 610, example defect classifier circuitry 612, example report generator circuitry 614, and example memory 616.

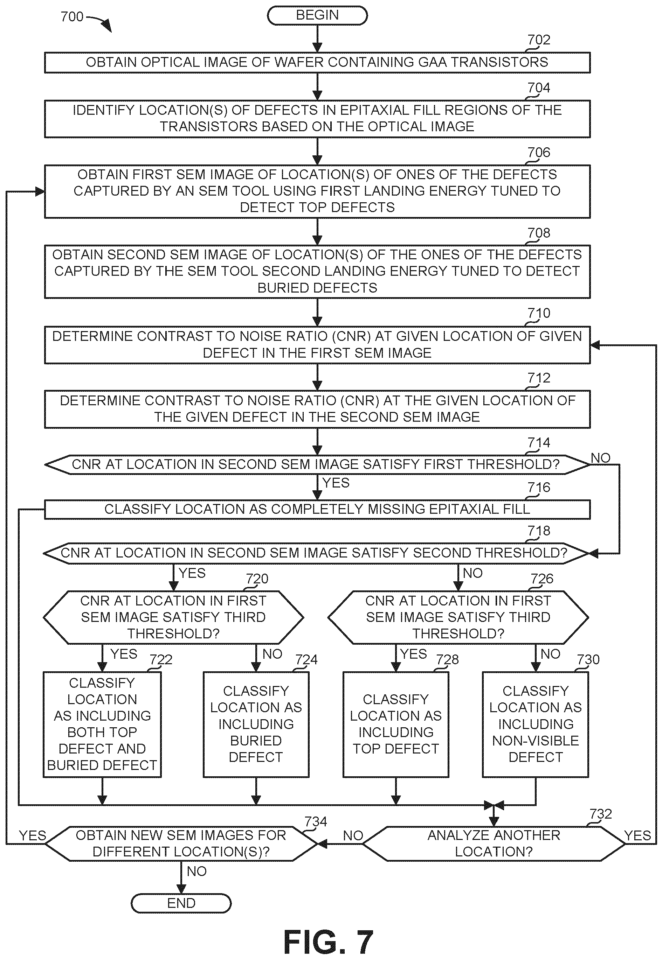

The example semiconductor inspection circuitry 516 is provided with the example interface circuitry 602 to enable communications with other components and/or external devices used during a semiconductor inspection process. Specifically, in some examples, the interface circuitry 602 communicates with an optical scanning tool to cause, direct, and/or control the capture of one or more optical images of a semiconductor wafer and/or portion thereof. In some examples, the optical scanning tool is controlled independent of the example semiconductor inspection circuitry 516. In such examples, the interface circuitry 602 enables the semiconductor inspection circuitry 516 to access, receive, and/or otherwise obtain outputs (e.g., captured optical images or scans) of the optical scanning tool. Similarly, in some examples, the interface circuitry 602 communicates with an SEM tool to cause, direct, and/or control the capture of one or more SEM images of a semiconductor wafer and/or portion thereof. In some examples, the SEM tool is controlled independent of the example semiconductor inspection circuitry 516. In such examples, the interface circuitry 602 enables the semiconductor inspection circuitry 516 to access, receive, and/or otherwise obtain outputs (e.g., captured SEM images or scans) of the SEM tool. In some examples, the interface circuitry 602 is instantiated by programmable circuitry executing interface instructions and/or configured to perform operations such as those represented by the flowchart of FIG. 7.

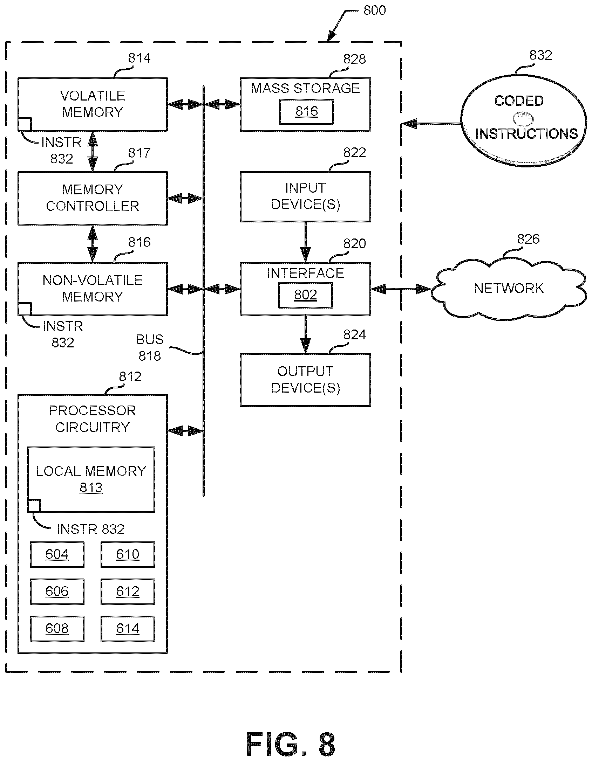

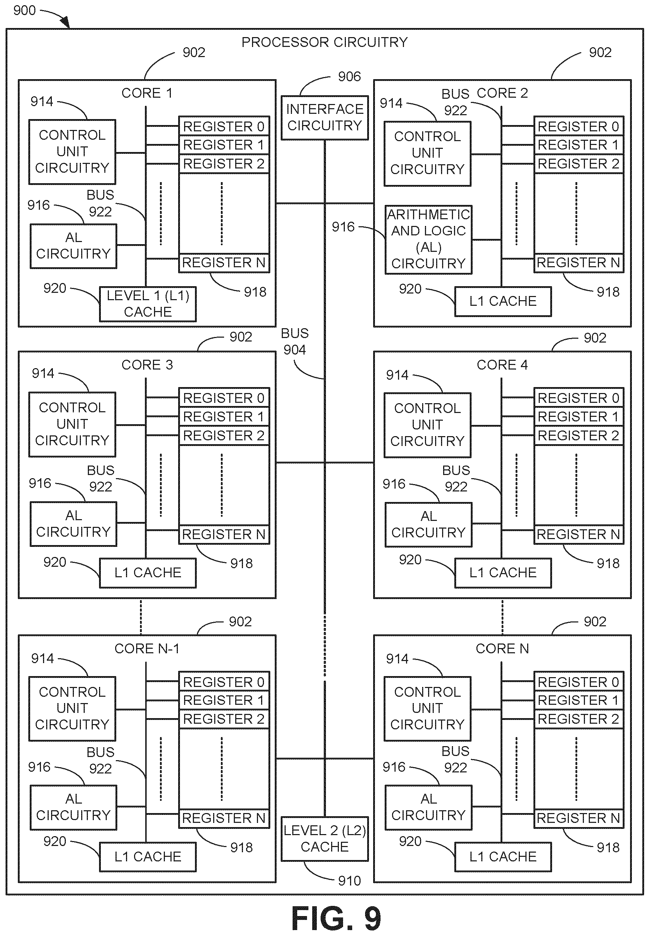

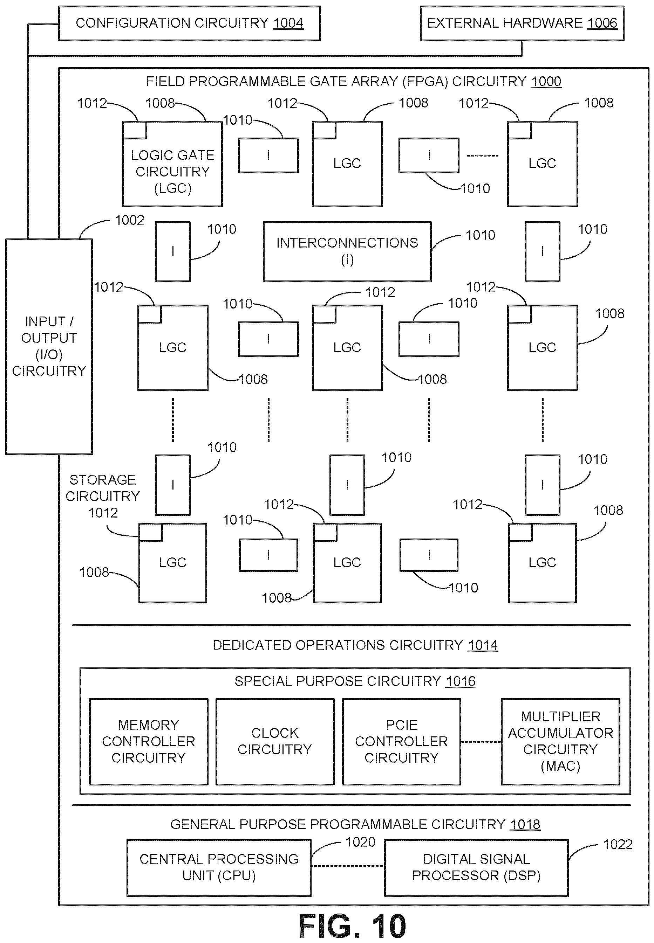

In some examples, the semiconductor inspection circuitry 516 includes means for communicating. For example, the means for communicating may be implemented by interface circuitry 602. In some examples, the interface circuitry 602 may be instantiated by programmable circuitry such as the example programmable circuitry 812 of FIG. 8. For instance, the interface circuitry 602 may be instantiated by the example microprocessor 900 of FIG. 9 executing machine executable instructions such as those implemented by at least blocks 702, 706, 708 of FIG. 7. In some examples, the interface circuitry 602 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the interface circuitry 602 may be instantiated by any other combination of hardware, software, and/or firmware. For example, the interface circuitry 602 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example optical tool controller circuitry 604 to control operations of an optical scanning tool (e.g., the optical scanning tool 502 of FIG. 5). That is, in some examples, the optical tool controller circuitry 604 generates commands (provided via the interface circuitry 602) that cause the optical scanning tool 502 to capture an optical image. In some examples, the optical tool controller circuitry 604 is instantiated by programmable circuitry executing optical tool controller instructions and/or configured to perform operations such as those represented by the flowchart of FIG. 7.

In some examples, the semiconductor inspection circuitry 516 includes means for obtaining an optical image. For example, the means for obtaining an optical image may be implemented by optical tool controller circuitry 604. In some examples, the optical tool controller circuitry 604 may be instantiated by programmable circuitry such as the example programmable circuitry 812 of FIG. 8. For instance, the optical tool controller circuitry 604 may be instantiated by the example microprocessor 900 of FIG. 9 executing machine executable instructions such as those implemented by at least blocks 702 of FIG. 7. In some examples, the optical tool controller circuitry 604 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the optical tool controller circuitry 604 may be instantiated by any other combination of hardware, software, and/or firmware. For example, the optical tool controller circuitry 604 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example defect identifier circuitry 606 to identify the locations of potential defects based on an analysis of an optical image obtained by the optical tool controller circuitry 604 (e.g., in communication with the optical scanning tool 502 via the interface circuitry 602). In some examples, the optical scanning tool 502 is a bright field inspection tool that shines a specific wavelength of light onto a semiconductor wafer to be inspected. In some examples, the one or more sensors 508 of the optical scanning tool 502 capture (e.g., in an image) the light reflected off the surface of the semiconductor wafer. The example defect identifier circuitry 606 may implement any suitable image analysis process to identify and flag the location(s) on the wafer having potential defects associated with missing epitaxial fill 122. In some examples, the image captured by the optical scanning tool 502 and/or the location(s) of potential defects are stored in the memory 616. In some examples, the defect identifier circuitry 606 is instantiated by programmable circuitry executing defect identifier instructions and/or configured to perform operations such as those represented by the flowchart of FIG. 7.

In some examples, the optical scanning tool 502 may perform the analysis of the defect identifier circuitry 606 and provide the resulting potential defect locations to the semiconductor inspection circuitry 516 via the interface circuitry 602. In such examples, the defect identifier circuitry 606 may be omitted.

In some examples, the semiconductor inspection circuitry 516 includes means for determining location(s) of defects and/or means for identifying potential defects. For example, the means for determining and/or the means for identifying may be implemented by defect identifier circuitry 606. In some examples, the defect identifier circuitry 606 may be instantiated by programmable circuitry such as the example programmable circuitry 812 of FIG. 8. For instance, the defect identifier circuitry 606 may be instantiated by the example microprocessor 900 of FIG. 9 executing machine executable instructions such as those implemented by at least blocks 704 of FIG. 7. In some examples, the defect identifier circuitry 606 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the defect identifier circuitry 606 may be instantiated by any other combination of hardware, software, and/or firmware. For example, the defect identifier circuitry 606 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example SEM tool controller circuitry 608 to control operations of an SEM tool (e.g., the SEM tool 504 of FIG. 5). That is, in some examples, the SEM tool controller circuitry 608 generates commands (provided via the interface circuitry 602) that cause the SEM tool 504 to capture an SEM image. In some examples, the commands include identifying the location(s) to be scanned or imaged by the SEM tool 504 based on the location(s) of potential defects identified by the defect identifier circuitry 606 based on an analysis of the optical image(s) captured by the optical scanning tool 502. Further, in some examples, the SEM tool controller 608 defines the parameters for the SEM tool 504 when capturing the images. Specifically, in some examples, the SEM tool controller 608 defines the landing energy for the electron beam to be used when generating an SEM image. In some examples, the SEM tool controller 608 directs or causes the SEM tool 504 to generate two SEM images for a given location based on two different landing energies including a relatively high landing energy tuned to detect buried defects and a relatively low landing energy tuned to detect top defects. In some examples, the SEM images captured by the SEM tool 504 are stored in the memory 616. In some examples, the SEM tool controller circuitry 608 is instantiated by programmable circuitry executing SEM tool controller instructions and/or configured to perform operations such as those represented by the flowchart of FIG. 7.

In some examples, the semiconductor inspection circuitry 516 includes means for obtaining an SEM image. For example, the means for obtaining an SEM image may be implemented by SEM tool controller circuitry 608. In some examples, the SEM tool controller circuitry 608 may be instantiated by programmable circuitry such as the example programmable circuitry 812 of FIG. 8. For instance, the SEM tool controller circuitry 608 may be instantiated by the example microprocessor 900 of FIG. 9 executing machine executable instructions such as those implemented by at least blocks 706, 708, 734 of FIG. 7. In some examples, the SEM tool controller circuitry 608 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the SEM tool controller circuitry 608 may be instantiated by any other combination of hardware, software, and/or firmware. For example, the SEM tool controller circuitry 608 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example CNR determiner circuitry 610 to determine the contrast to noise ratios (CNRs) in the SEM images obtained by the SEM tool controller circuitry 608 (e.g., in communication with the SEM tool 504 via the interface circuitry 602) associated with pixels corresponding to the location(s) of potential defects identified by the defect identifier circuitry 606. In some examples, the CNR determiner circuitry 610 determines the CNRs by first segmenting the SEM images to isolate the pixels associated with the potential defects (e.g., the locations associated with epitaxial regions 124, 126, 128 at which an analysis of the optical image indicates the possibility of missing epitaxial fill 122) and separate such pixels from the surrounding background. The example CNR determiner circuitry 610 determines a grey level intensity for the segmented pixels from which a CNR value is calculated. In some examples, the resulting CNR values are stored in the memory 616. In some examples, the CNR values are stored in a data structure or format that enables the CNR values to be associated with the corresponding location(s) of the potential defect. In some examples, the CNR determiner circuitry 610 is instantiated by programmable circuitry executing CNR determiner instructions and/or configured to perform operations such as those represented by the flowchart of FIG. 7.

In some examples, the semiconductor inspection circuitry 516 includes means for determining a CNR. For example, the means for determining a CNR may be implemented by CNR determiner circuitry 610. In some examples, the CNR determiner circuitry 610 may be instantiated by programmable circuitry such as the example programmable circuitry 812 of FIG. 8. For instance, the CNR determiner circuitry 610 may be instantiated by the example microprocessor 900 of FIG. 9 executing machine executable instructions such as those implemented by at least blocks 710, 712, 732 of FIG. 7. In some examples, the CNR determiner circuitry 610 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the CNR determiner circuitry 610 may be instantiated by any other combination of hardware, software, and/or firmware. For example, the CNR determiner circuitry 610 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example defect classifier circuitry 612 to compare the CNR values (determined by the CNR determiner circuitry 610) to corresponding thresholds to determine or classify the type of defect(s) at the locations(s) associated with the CNR values. In some examples, the defect classifier circuitry 612 determines the types of defect(s) based on the information contained in the truth table 400 of FIG. 4. In some examples, the resulting classifications of the defects are stored in the memory 616. In some examples, the defect classifier circuitry 612 is instantiated by programmable circuitry executing defect classifier instructions and/or configured to perform operations such as those represented by the flowchart of FIG. 7.

In some examples, the semiconductor inspection circuitry 516 includes means for determining a type of defect and/or means for classifying a defect. For example, the means for determining and/or the means for classifying may be implemented by defect classifier circuitry 612. In some examples, the defect classifier circuitry 612 may be instantiated by programmable circuitry such as the example programmable circuitry 812 of FIG. 8. For instance, the defect classifier circuitry 612 may be instantiated by the example microprocessor 900 of FIG. 9 executing machine executable instructions such as those implemented by at least blocks 714, 716, 718, 720, 722, 724, 726, 728, 730 of FIG. 7. In some examples, the defect classifier circuitry 612 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the defect classifier circuitry 612 may be instantiated by any other combination of hardware, software, and/or firmware. For example, the defect classifier circuitry 612 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

The example semiconductor inspection circuitry 516 is provided with the example report generator circuitry 614 to generate a report based on the types of defects determined for the corresponding locations on a semiconductor wafer being inspected. In some examples, the report generator circuitry 614 generates this report based on the data structure containing such information stored in the example memory 616. The stored data structure and/or the resulting report can be in any suitable format. In some examples, the report generator circuitry 614 is instantiated by programmable circuitry executing report generator instructions and/or configured to perform operations such as those represented by the flowchart of FIG. 7.

In some examples, the semiconductor inspection circuitry 516 includes means for generating a report. For example, the means for generating may be implemented by report generator circuitry 614. In some examples, the report generator circuitry 614 may be instantiated by programmable circuitry such as the example programmable circuitry 812 of FIG. 8. In some examples, the report generator circuitry 614 may be instantiated by hardware logic circuitry, which may be implemented by an ASIC, XPU, or the FPGA circuitry 1000 of FIG. 10 configured and/or structured to perform operations corresponding to the machine readable instructions. Additionally or alternatively, the report generator circuitry 614 may be instantiated by any other combination of hardware, software, and/or firmware. For example, the report generator circuitry 614 may be implemented by at least one or more hardware circuits (e.g., processor circuitry, discrete and/or integrated analog and/or digital circuitry, an FPGA, an ASIC, an XPU, a comparator, an operational-amplifier (op-amp), a logic circuit, etc.) configured and/or structured to execute some or all of the machine readable instructions and/or to perform some or all of the operations corresponding to the machine readable instructions without executing software or firmware, but other structures are likewise appropriate.

While an example manner of implementing the semiconductor inspection circuitry 516 of FIG. 1 is illustrated in FIG. 6, one or more of the elements, processes, and/or devices illustrated in FIG. 6 may be combined, divided, re-arranged, omitted, eliminated, and/or implemented in any other way. Further, the example interface circuitry 602, the example optical tool controller circuitry 604, the example defect identifier circuitry 606, the example SEM tool controller circuitry 608, the example CNR determiner circuitry 610, the example defect classifier circuitry 612, the example report generator circuitry 614, the example memory 616, and/or, more generally, the example semiconductor inspection circuitry 516 of FIG. 6, may be implemented by hardware alone or by hardware in combination with software and/or firmware. Thus, for example, any of the example interface circuitry 602, the example optical tool controller circuitry 604, the example defect identifier circuitry 606, the example SEM tool controller circuitry 608, the example CNR determiner circuitry 610, the example defect classifier circuitry 612, the example report generator circuitry 614, the example memory 616, and/or, more generally, the example semiconductor inspection circuitry 516, could be implemented by programmable circuitry in combination with machine readable instructions (e.g., firmware or software), processor circuitry, analog circuit(s), digital circuit(s), logic circuit(s), programmable processor(s), programmable microcontroller(s), graphics processing unit(s) (GPU(s)), digital signal processor(s) (DSP(s)), ASIC(s), programmable logic device(s) (PLD(s)), and/or field programmable logic device(s) (FPLD(s)) such as FPGAs. Further still, the example semiconductor inspection circuitry 516 of FIG. 6 may include one or more elements, processes, and/or devices in addition to, or instead of, those illustrated in FIG. 6, and/or may include more than one of any or all of the illustrated elements, processes and devices.

A flowchart representative of example machine readable instructions, which may be executed by programmable circuitry to implement and/or instantiate the semiconductor inspection circuitry 516 of FIG. 6 and/or representative of example operations which may be performed by programmable circuitry to implement and/or instantiate the semiconductor inspection circuitry 516 of FIG. 6, is shown in FIG. 7. The machine readable instructions may be one or more executable programs or portion(s) of one or more executable programs for execution by programmable circuitry such as the programmable circuitry 812 shown in the example processor platform 800 discussed below in connection with FIG. 8 and/or may be one or more function(s) or portion(s) of functions to be performed by the example programmable circuitry (e.g., an FPGA) discussed below in connection with FIGS. 9 and/or 10. In some examples, the machine readable instructions cause an operation, a task, etc., to be carried out and/or performed in an automated manner in the real world. As used herein, "automated" means without human involvement.

The program may be embodied in instructions (e.g., software and/or firmware) stored on one or more non-transitory computer readable and/or machine readable storage medium such as cache memory, a magnetic-storage device or disk (e.g., a floppy disk, a Hard Disk Drive (HDD), etc.), an optical-storage device or disk (e.g., a Blu-ray disk, a Compact Disk (CD), a Digital Versatile Disk (DVD), etc.), a Redundant Array of Independent Disks (RAID), a register, ROM, a solid-state drive (SSD), SSD memory, non-volatile memory (e.g., electrically erasable programmable read-only memory (EEPROM), flash memory, etc.), volatile memory (e.g., Random Access Memory (RAM) of any type, etc.), and/or any other storage device or storage disk. The instructions of the non-transitory computer readable and/or machine readable medium may program and/or be executed by programmable circuitry located in one or more hardware devices, but the entire program and/or parts thereof could alternatively be executed and/or instantiated by one or more hardware devices other than the programmable circuitry and/or embodied in dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a human and/or machine user) or an intermediate client hardware device gateway (e.g., a radio access network (RAN)) that may facilitate communication between a server and an endpoint client hardware device. Similarly, the non-transitory computer readable storage medium may include one or more mediums. Further, although the example program is described with reference to the flowchart illustrated in FIG. 7, many other methods of implementing the example semiconductor inspection circuitry 516 may alternatively be used. For example, the order of execution of the blocks of the flowchart may be changed, and/or some of the blocks described may be changed, eliminated, or combined. Additionally or alternatively, any or all of the blocks of the flow chart may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The programmable circuitry may be distributed in different network locations and/or local to one or more hardware devices (e.g., a single-core processor (e.g., a single core CPU), a multi-core processor (e.g., a multi-core CPU, an XPU, etc.)). For example, the programmable circuitry may be a CPU and/or an FPGA located in the same package (e.g., the same integrated circuit (IC) package or in two or more separate housings), one or more processors in a single machine, multiple processors distributed across multiple servers of a server rack, multiple processors distributed across one or more server racks, etc., and/or any combination(s) thereof.

The machine readable instructions described herein may be stored in one or more of a compressed format, an encrypted format, a fragmented format, a compiled format, an executable format, a packaged format, etc. Machine readable instructions as described herein may be stored as data (e.g., computer-readable data, machine-readable data, one or more bits (e.g., one or more computer-readable bits, one or more machine-readable bits, etc.), a bitstream (e.g., a computer-readable bitstream, a machine-readable bitstream, etc.), etc.) or a data structure (e.g., as portion(s) of instructions, code, representations of code, etc.) that may be utilized to create, manufacture, and/or produce machine executable instructions. For example, the machine readable instructions may be fragmented and stored on one or more storage devices, disks and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of computer-executable and/or machine executable instructions that implement one or more functions and/or operations that may together form a program such as that described herein.

In another example, the machine readable instructions may be stored in a state in which they may be read by programmable circuitry, but require addition of a library (e.g., a dynamic link library (DLL)), a software development kit (SDK), an application programming interface (API), etc., in order to execute the machine-readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable, computer readable and/or machine readable media, as used herein, may include instructions and/or program(s) regardless of the particular format or state of the machine readable instructions and/or program(s).

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIG. 7 may be implemented using executable instructions (e.g., computer readable and/or machine readable instructions) stored on one or more non-transitory computer readable and/or machine readable media. As used herein, the terms non-transitory computer readable medium, non-transitory computer readable storage medium, non-transitory machine readable medium, and/or non-transitory machine readable storage medium are expressly defined to include any type of computer readable storage device and/or storage disk and to exclude propagating signals and to exclude transmission media. Examples of such non-transitory computer readable medium, non-transitory computer readable storage medium, non-transitory machine readable medium, and/or non-transitory machine readable storage medium include optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms "non-transitory computer readable storage device" and "non-transitory machine readable storage device" are defined to include any physical (mechanical, magnetic and/or electrical) hardware to retain information for a time period, but to exclude propagating signals and to exclude transmission media. Examples of non-transitory computer readable storage devices and/ or non-transitory machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer-readable instructions, machine-readable instructions, etc.

FIG. 7 is a flowchart representative of example machine readable instructions and/or example operations 700 that may be executed, instantiated, and/or performed by programmable circuitry to detect defects associated with missing epitaxial fill in GAA transistors and to classify the type and/or nature of such defects. The example machine-readable instructions and/or the example operations 700 of FIG. 7 begin at block 702 where the optical tool controller circuitry 604 obtains an optical image of a wafer (e.g., the substrate 506 of FIG. 5) containing GAA transistors (e.g., the transistors 100, 200 of FIGS. 1 and/or 2). In some examples, the optical image is obtained via the example interface circuitry 602. At block 704, the example defect identifier circuitry 606 identifies location(s) of defects in epitaxial fill regions of the transistors based on the optical image. At block 706, the example SEM tool controller circuitry 608 obtains a first SEM image of location(s) of ones of the defects captured by an SEM tool (e.g., the SEM tool 504) using a first landing energy tuned to detect top defects. That is, in this examples, the first landing energy is defined to be relatively low. In some examples, the first SEM image is obtained via the example interface circuitry 602. At block 708, the example SEM tool controller circuitry 608 obtains a second SEM image of the location(s) of the ones of the defects captured by the SEM tool 504 using a second landing energy tuned to detect buried defects. That is, in this example, the second SEM image is of the same location(s) as the first SEM image, but the second landing energy is defined to be relatively high. In some examples, the second SEM image is obtained via the example interface circuitry 602. In the flowchart of FIG. 7, the low landing energy SEM image is obtained (e.g., captured) first. However, in other examples, the high landing energy SEM image can be obtained (e.g., captured) first.

At block 710, the example CNR determiner circuitry 610 determines a contrast to noise ratio (CNR) at a given location of a given defect in the first SEM image. At block 712, the example CNR determiner circuitry 610 determines a contrast to noise ratio (CNR) at the given location of the given defect in the second SEM image. In some examples, the order in which the first and second SEM images are analyzed may be reversed from what is represented in FIG. 7. Further, in some examples, the analysis of the SEM images can occur immediately after the corresponding SEM image is obtained. That is, in some examples, block 710 may be implemented immediately after block 706 and before block 708.

At block 714, the example defect classifier circuitry 612 determines whether the CNR at the location in the second SEM image (e.g., the CNR_{HLE} of FIG. 4) satisfies (e.g., assuming negative values, is less than) a first threshold (e.g., TH₁ in FIG. 4). If so, the example defect classifier circuitry 612 classifies the location as completely missing the epitaxial fill 122. Thereafter, control advances to block 732. If, on the other hand, the example defect classifier circuitry 612 determines (at block 714) that the CNR_{HLE} does not satisfy the first threshold, control advances to block 718.

At block 718, the example defect classifier circuitry 612 determines whether the CNR at the location in the second SEM image (e.g., the CNR_{HLE} of FIG. 4) satisfies (e.g., assuming negative values, is less than) a second threshold (e.g., TH₂ in FIG. 4). If so, control advances to block 720 where the example defect classifier circuitry 612 determines whether the CNR at the location in the first SEM image (e.g., the CNR_{LLE} of FIG. 4) satisfies (e.g., assuming negative values, is less than) a third threshold (e.g., TH₃ in FIG. 4). If so, control advances to block 722 where the example defect classifier circuitry 612 classifies the location as including both a top defect and a buried defect. Thereafter, control advances to block 732. Returning to block 720, if the example defect classifier circuitry 612 determines the CNR at the location in the first SEM image (e.g., the CNR_{LLE} of FIG. 4) does not satisfy the third threshold (after having determined the CNR_{HLE} satisfies the second threshold (at block 718)), the example defect classifier circuitry 612 classifies the location as including a buried defect (block 724). Thereafter, control advances to block 732.

Returning to block 718, if the example defect classifier circuitry 612 determines that the CNR at the location in the second SEM image (e.g., the CNR_{HLE} of FIG. 4) does not satisfy the second threshold, control advances to block 726. At block 726, the example defect classifier circuitry 612 determines whether the CNR at the location in the first SEM image (e.g., the CNR_{LLE} of FIG. 4) satisfies the third threshold. If so, control advances to block 728 where the example defect classifier circuitry 612 classifies the location as including a top defect. Thereafter, control advances to block 732. Returning to block 726, if the example defect classifier circuitry 612 determines the CNR at the location in the first SEM image (e.g., the CNR_{LLE} of FIG. 4) does not satisfy the third threshold (after having determined the CNR_{HLE} does not satisfy the second threshold (at block 718)), the example defect classifier circuitry 612 classifies the location as including a non-visible defect (block 730). Thereafter, control advances to block 732.

At block 732, the CNR determiner circuitry 610 determines whether to analyze another location. If so, control returns to block 710 to determine the CNR for the next location. In some examples, the CNRs for multiple (e.g., all) locations in the SEM images may be determined before the CNRs are analyzed to classify the types of defects associated with the corresponding locations. Thus, in such examples, blocks 710, and 712 would not need to be repeated. Instead, control would return to block 714. If, at block 732, the CNR determiner circuitry 610 determines there are no other locations to analyze, control advances to block 734.

At block 734, the example SEM tool controller circuitry 608 determines whether to obtain new SEM images for different location(s). If so, control returns to block 706. In some examples, all SEM images for all identified locations can be captured prior to any subsequent analysis. In some examples, all SEM images based on the first (low) landing energy may be obtained prior to obtaining any SEM images based on the second (high) landing energy. In other examples, both the high and low landing energies are used to generate the corresponding SEM images at a given location prior to moving to the next location. If the SEM tool controller circuitry 608 determines (at block 734) that no further SEM images are needed, the example process of FIG. 7 ends.

FIG. 8 is a block diagram of an example programmable circuitry platform 800 structured to execute and/or instantiate the example machine-readable instructions and/or the example operations of FIG. 7 to implement the semiconductor inspection circuitry 516 of FIG. 6. The programmable circuitry platform 800 can be, for example, a server, a personal computer, a workstation, a self-learning machine (e.g., a neural network), a mobile device (e.g., a cell phone, a smart phone, a tablet such as an iPad^{™}), a personal digital assistant (PDA), an Internet appliance, a headset (e.g., an augmented reality (AR) headset, a virtual reality (VR) headset, etc.) or other wearable device, or any other type of computing and/or electronic device.

The programmable circuitry platform 800 of the illustrated example includes programmable circuitry 812. The programmable circuitry 812 of the illustrated example is hardware. For example, the programmable circuitry 812 can be implemented by one or more integrated circuits, logic circuits, FPGAs, microprocessors, CPUs, GPUs, DSPs, and/or microcontrollers from any desired family or manufacturer. The programmable circuitry 812 may be implemented by one or more semiconductor based (e.g., silicon based) devices. In this example, the programmable circuitry 812 implements the example optical tool controller circuitry 604, the example defect identifier circuitry 606, the example SEM tool controller circuitry 608, the example CNR determiner circuitry 610, the example defect classifier circuitry 612, and the example report generator circuitry 614.

The programmable circuitry 812 of the illustrated example includes a local memory 813 (e.g., a cache, registers, etc.). The programmable circuitry 812 of the illustrated example is in communication with main memory 814, 816, which includes a volatile memory 814 and a non-volatile memory 816, by a bus 818. The volatile memory 814 may be implemented by Synchronous Dynamic Random Access Memory (SDRAM), Dynamic Random Access Memory (DRAM), RAMBUS^{®} Dynamic Random Access Memory (RDRAM^{®}), and/or any other type of RAM device. The non-volatile memory 816 may be implemented by flash memory and/or any other desired type of memory device. Access to the main memory 814, 816 of the illustrated example is controlled by a memory controller 817. In some examples, the memory controller 817 may be implemented by one or more integrated circuits, logic circuits, microcontrollers from any desired family or manufacturer, or any other type of circuitry to manage the flow of data going to and from the main memory 814, 816.

The programmable circuitry platform 800 of the illustrated example also includes interface circuitry 820. The interface circuitry 820 may be implemented by hardware in accordance with any type of interface standard, such as an Ethernet interface, a universal serial bus (USB) interface, a Bluetooth^{®} interface, a near field communication (NFC) interface, a Peripheral Component Interconnect (PCI) interface, and/or a Peripheral Component Interconnect Express (PCIe) interface.

In the illustrated example, one or more input devices 822 are connected to the interface circuitry 820. The input device(s) 822 permit(s) a user (e.g., a human user, a machine user, etc.) to enter data and/or commands into the programmable circuitry 812. The input device(s) 822 can be implemented by, for example, an audio sensor, a microphone, a camera (still or video), a keyboard, a button, a mouse, a touchscreen, a trackpad, a trackball, an isopoint device, and/or a voice recognition system.

One or more output devices 824 are also connected to the interface circuitry 820 of the illustrated example. The output device(s) 824 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 820 of the illustrated example, thus, typically includes a graphics driver card, a graphics driver chip, and/or graphics processor circuitry such as a GPU.

The interface circuitry 820 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 826. The communication can be by, for example, an Ethernet connection, a digital subscriber line (DSL) connection, a telephone line connection, a coaxial cable system, a satellite system, a beyond-line-of-sight wireless system, a line-of-sight wireless system, a cellular telephone system, an optical connection, etc.

The programmable circuitry platform 800 of the illustrated example also includes one or more mass storage discs or devices 828 to store firmware, software, and/or data. Examples of such mass storage discs or devices 828 include magnetic storage devices (e.g., floppy disk, drives, HDDs, etc.), optical storage devices (e.g., Blu-ray disks, CDs, DVDs, etc.), RAID systems, and/or solid-state storage discs or devices such as flash memory devices and/or SSDs.

The machine readable instructions 832, which may be implemented by the machine readable instructions of FIG. 7dmay be stored in the mass storage device 828, in the volatile memory 814, in the non-volatile memory 816, and/or on at least one non-transitory computer readable storage medium such as a CD or DVD which may be removable.

FIG. 9 is a block diagram of an example implementation of the programmable circuitry 812 of FIG. 8. In this example, the programmable circuitry 812 of FIG. 8 is implemented by a microprocessor 900. For example, the microprocessor 900 may be a general-purpose microprocessor (e.g., general-purpose microprocessor circuitry). The microprocessor 900 executes some or all of the machine-readable instructions of the flowchart of FIG. 7 to effectively instantiate the circuitry of FIG. 2 as logic circuits to perform operations corresponding to those machine readable instructions. In some such examples, the circuitry of FIG. 6 is instantiated by the hardware circuits of the microprocessor 900 in combination with the machine-readable instructions. For example, the microprocessor 900 may be implemented by multi-core hardware circuitry such as a CPU, a DSP, a GPU, an XPU, etc. Although it may include any number of example cores 902 (e.g., 1 core), the microprocessor 900 of this example is a multi-core semiconductor device including N cores. The cores 902 of the microprocessor 900 may operate independently or may cooperate to execute machine readable instructions. For example, machine code corresponding to a firmware program, an embedded software program, or a software program may be executed by one of the cores 902 or may be executed by multiple ones of the cores 902 at the same or different times. In some examples, the machine code corresponding to the firmware program, the embedded software program, or the software program is split into threads and executed in parallel by two or more of the cores 902. The software program may correspond to a portion or all of the machine readable instructions and/or operations represented by the flowchart of FIG. 7.

The cores 902 may communicate by a first example bus 904. In some examples, the first bus 904 may be implemented by a communication bus to effectuate communication associated with one(s) of the cores 902. For example, the first bus 904 may be implemented by at least one of an Inter-Integrated Circuit (12C) bus, a Serial Peripheral Interface (SPI) bus, a PCI bus, or a PCIe bus. Additionally or alternatively, the first bus 904 may be implemented by any other type of computing or electrical bus. The cores 902 may obtain data, instructions, and/or signals from one or more external devices by example interface circuitry 906. The cores 902 may output data, instructions, and/or signals to the one or more external devices by the interface circuitry 906. Although the cores 902 of this example include example local memory 920 (e.g., Level 1 (L1) cache that may be split into an L1 data cache and an L1 instruction cache), the microprocessor 900 also includes example shared memory 910 that may be shared by the cores (e.g., Level 2 (L2 cache)) for high-speed access to data and/or instructions. Data and/or instructions may be transferred (e.g., shared) by writing to and/or reading from the shared memory 910. The local memory 920 of each of the cores 902 and the shared memory 910 may be part of a hierarchy of storage devices including multiple levels of cache memory and the main memory (e.g., the main memory 814, 816 of FIG. 8). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 902 may be referred to as a CPU, DSP, GPU, etc., or any other type of hardware circuitry. Each core 902 includes control unit circuitry 914, arithmetic and logic (AL) circuitry (sometimes referred to as an ALU) 916, a plurality of registers 918, the local memory 920, and a second example bus 922. Other structures may be present. For example, each core 902 may include vector unit circuitry, single instruction multiple data (SIMD) unit circuitry, load/store unit (LSU) circuitry, branch/jump unit circuitry, floating-point unit (FPU) circuitry, etc. The control unit circuitry 914 includes semiconductor-based circuits structured to control (e.g., coordinate) data movement within the corresponding core 902. The AL circuitry 916 includes semiconductor-based circuits structured to perform one or more mathematic and/or logic operations on the data within the corresponding core 902. The AL circuitry 916 of some examples performs integer based operations. In other examples, the AL circuitry 916 also performs floating-point operations. In yet other examples, the AL circuitry 916 may include first AL circuitry that performs integer-based operations and second AL circuitry that performs floating-point operations. In some examples, the AL circuitry 916 may be referred to as an Arithmetic Logic Unit (ALU).

The registers 918 are semiconductor-based structures to store data and/or instructions such as results of one or more of the operations performed by the AL circuitry 916 of the corresponding core 902. For example, the registers 918 may include vector register(s), SIMD register(s), general-purpose register(s), flag register(s), segment register(s), machine-specific register(s), instruction pointer register(s), control register(s), debug register(s), memory management register(s), machine check register(s), etc. The registers 918 may be arranged in a bank as shown in FIG. 9. Alternatively, the registers 918 may be organized in any other arrangement, format, or structure, such as by being distributed throughout the core 902 to shorten access time. The second bus 922 may be implemented by at least one of an I2C bus, a SPI bus, a PCI bus, or a PCIe bus.

Each core 902 and/or, more generally, the microprocessor 900 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 900 is a semiconductor device fabricated to include many transistors interconnected to implement the structures described above in one or more integrated circuits (ICs) contained in one or more packages.

The microprocessor 900 may include and/or cooperate with one or more accelerators (e.g., acceleration circuitry, hardware accelerators, etc.). In some examples, accelerators are implemented by logic circuitry to perform certain tasks more quickly and/or efficiently than can be done by a general-purpose processor. Examples of accelerators include ASICs and FPGAs such as those discussed herein. A GPU, DSP and/or other programmable device can also be an accelerator. Accelerators may be on-board the microprocessor 900, in the same chip package as the microprocessor 900 and/or in one or more separate packages from the microprocessor 900.

FIG. 10 is a block diagram of another example implementation of the programmable circuitry 812 of FIG. 8. In this example, the programmable circuitry 812 is implemented by FPGA circuitry 1000. For example, the FPGA circuitry 1000 may be implemented by an FPGA. The FPGA circuitry 1000 can be used, for example, to perform operations that could otherwise be performed by the example microprocessor 900 of FIG. 9 executing corresponding machine readable instructions. However, once configured, the FPGA circuitry 1000 instantiates the operations and/or functions corresponding to the machine readable instructions in hardware and, thus, can often execute the operations/functions faster than they could be performed by a general-purpose microprocessor executing the corresponding software.

More specifically, in contrast to the microprocessor 900 of FIG. 9 described above (which is a general purpose device that may be programmed to execute some or all of the machine readable instructions represented by the flowchart of FIG. 7 but whose interconnections and logic circuitry are fixed once fabricated), the FPGA circuitry 1000 of the example of FIG. 10 includes interconnections and logic circuitry that may be configured, structured, programmed, and/or interconnected in different ways after fabrication to instantiate, for example, some or all of the operations/functions corresponding to the machine readable instructions represented by the flowchart of FIG. 7. In particular, the FPGA circuitry 1000 may be thought of as an array of logic gates, interconnections, and switches. The switches can be programmed to change how the logic gates are interconnected by the interconnections, effectively forming one or more dedicated logic circuits (unless and until the FPGA circuitry 1000 is reprogrammed). The configured logic circuits enable the logic gates to cooperate in different ways to perform different operations on data received by input circuitry. Those operations may correspond to some or all of the instructions (e.g., the software and/or firmware) represented by the flowchart of FIG. 7. As such, the FPGA circuitry 1000 may be configured and/or structured to effectively instantiate some or all of the operations/functions corresponding to the machine readable instructions of the flowchart of FIG. 7 as dedicated logic circuits to perform the operations/functions corresponding to those software instructions in a dedicated manner analogous to an ASIC. Therefore, the FPGA circuitry 1000 may perform the operations/functions corresponding to the some or all of the machine readable instructions of FIG. 7 faster than the general-purpose microprocessor can execute the same.

In the example of FIG. 10, the FPGA circuitry 1000 is configured and/or structured in response to being programmed (and/or reprogrammed one or more times) based on a binary file. In some examples, the binary file may be compiled and/or generated based on instructions in a hardware description language (HDL) such as Lucid, Very High Speed Integrated Circuits (VHSIC) Hardware Description Language (VHDL), or Verilog. For example, a user (e.g., a human user, a machine user, etc.) may write code or a program corresponding to one or more operations/functions in an HDL; the code/program may be translated into a low-level language as needed; and the code/program (e.g., the code/program in the low-level language) may be converted (e.g., by a compiler, a software application, etc.) into the binary file. In some examples, the FPGA circuitry 1000 of FIG. 10 may access and/or load the binary file to cause the FPGA circuitry 1000 of FIG. 10 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1000 of FIG. 10 to cause configuration and/or structuring of the FPGA circuitry 1000 of FIG. 10, or portion(s) thereof.

In some examples, the binary file is compiled, generated, transformed, and/or otherwise output from a uniform software platform utilized to program FPGAs. For example, the uniform software platform may translate first instructions (e.g., code or a program) that correspond to one or more operations/functions in a high-level language (e.g., C, C++, Python, etc.) into second instructions that correspond to the one or more operations/functions in an HDL. In some such examples, the binary file is compiled, generated, and/or otherwise output from the uniform software platform based on the second instructions. In some examples, the FPGA circuitry 1000 of FIG. 10 may access and/or load the binary file to cause the FPGA circuitry 1000 of FIG. 10 to be configured and/or structured to perform the one or more operations/functions. For example, the binary file may be implemented by a bit stream (e.g., one or more computer-readable bits, one or more machine-readable bits, etc.), data (e.g., computer-readable data, machine-readable data, etc.), and/or machine-readable instructions accessible to the FPGA circuitry 1000 of FIG. 10 to cause configuration and/or structuring of the FPGA circuitry 1000 of FIG. 10, or portion(s) thereof.

The FPGA circuitry 1000 of FIG. 10, includes example input/output (I/O) circuitry 1002 to obtain and/or output data to/from example configuration circuitry 1004 and/or external hardware 1006. For example, the configuration circuitry 1004 may be implemented by interface circuitry that may obtain a binary file, which may be implemented by a bit stream, data, and/or machine-readable instructions, to configure the FPGA circuitry 1000, or portion(s) thereof. In some such examples, the configuration circuitry 1004 may obtain the binary file from a user, a machine (e.g., hardware circuitry (e.g., programmable or dedicated circuitry) that may implement an Artificial Intelligence/Machine Learning (AI/ML) model to generate the binary file), etc., and/or any combination(s) thereof). In some examples, the external hardware 1006 may be implemented by external hardware circuitry. For example, the external hardware 1006 may be implemented by the microprocessor 900 of FIG. 9.

The FPGA circuitry 1000 also includes an array of example logic gate circuitry 1008, a plurality of example configurable interconnections 1010, and example storage circuitry 1012. The logic gate circuitry 1008 and the configurable interconnections 1010 are configurable to instantiate one or more operations/functions that may correspond to at least some of the machine readable instructions of FIG. 7 and/or other desired operations. The logic gate circuitry 1008 shown in FIG. 10 is fabricated in blocks or groups. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1008 to enable configuration of the electrical structures and/or the logic gates to form circuits to perform desired operations/functions. The logic gate circuitry 1008 may include other electrical structures such as look-up tables (LUTs), registers (e.g., flip-flops or latches), multiplexers, etc.

The configurable interconnections 1010 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1008 to program desired logic circuits.

The storage circuitry 1012 of the illustrated example is structured to store result(s) of the one or more of the operations performed by corresponding logic gates. The storage circuitry 1012 may be implemented by registers or the like. In the illustrated example, the storage circuitry 1012 is distributed amongst the logic gate circuitry 1008 to facilitate access and increase execution speed.

The example FPGA circuitry 1000 of FIG. 10 also includes example dedicated operations circuitry 1014. In this example, the dedicated operations circuitry 1014 includes special purpose circuitry 1016 that may be invoked to implement commonly used functions to avoid the need to program those functions in the field. Examples of such special purpose circuitry 1016 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1000 may also include example general purpose programmable circuitry 1018 such as an example CPU 1020 and/or an example DSP 1022. Other general purpose programmable circuitry 1018 may additionally or alternatively be present such as a GPU, an XPU, etc., that can be programmed to perform other operations.

Although FIGS. 9 and 10 illustrate two example implementations of the programmable circuitry 812 of FIG. 8, many other approaches are contemplated. For example, FPGA circuitry may include an on-board CPU, such as one or more of the example CPU 1020 of FIG. 9. Therefore, the programmable circuitry 812 of FIG. 8 may additionally be implemented by combining at least the example microprocessor 900 of FIG. 9 and the example FPGA circuitry 1000 of FIG. 10. In some such hybrid examples, one or more cores 902 of FIG. 9 may execute a first portion of the machine readable instructions represented by the flowchart of FIG. 7 to perform first operation(s)/function(s), the FPGA circuitry 1000 of FIG. 10 may be configured and/or structured to perform second operation(s)/function(s) corresponding to a second portion of the machine readable instructions represented by the flowchart of FIG. 7, and/or an ASIC may be configured and/or structured to perform third operation(s)/function(s) corresponding to a third portion of the machine readable instructions represented by the flowchart of FIG. 7.

It should be understood that some or all of the circuitry of FIG. 6 may, thus, be instantiated at the same or different times. For example, same and/or different portion(s) of the microprocessor 900 of FIG. 9 may be programmed to execute portion(s) of machine-readable instructions at the same and/or different times. In some examples, same and/or different portion(s) of the FPGA circuitry 1000 of FIG. 10 may be configured and/or structured to perform operations/functions corresponding to portion(s) of machine-readable instructions at the same and/or different times.

In some examples, some or all of the circuitry of FIG. 6 may be instantiated, for example, in one or more threads executing concurrently and/or in series. For example, the microprocessor 900 of FIG. 9 may execute machine readable instructions in one or more threads executing concurrently and/or in series. In some examples, the FPGA circuitry 1000 of FIG. 10 may be configured and/or structured to carry out operations/functions concurrently and/or in series. Moreover, in some examples, some or all of the circuitry of FIG. 6 may be implemented within one or more virtual machines and/or containers executing on the microprocessor 900 of FIG. 9.

In some examples, the programmable circuitry 812 of FIG. 8 may be in one or more packages. For example, the microprocessor 900 of FIG. 9 and/or the FPGA circuitry 1000 of FIG. 10 may be in one or more packages. In some examples, an XPU may be implemented by the programmable circuitry 812 of FIG. 8, which may be in one or more packages. For example, the XPU may include a CPU (e.g., the microprocessor 900 of FIG. 9, the CPU 1020 of FIG. 10, etc.) in one package, a DSP (e.g., the DSP 1022 of FIG. 10) in another package, a GPU in yet another package, and an FPGA (e.g., the FPGA circuitry 1000 of FIG. 10) in still yet another package.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein "substantially real time" refers to occurrence in a near instantaneous manner recognizing there may be real world delays for computing time, transmission, etc. Thus, unless otherwise specified, "substantially real time" refers to real time + 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that enable the detection of top defects and buried defects within epitaxial fill regions of GAA transistors and distinguishing between such defects. The detection of such defects can be accomplished immediately following the deposition (e.g., epitaxial growth) of the epitaxial fill material in such regions. As such, examples disclosed herein can be implemented inline during the semiconductor fabrication process flow without significant delays due to subsequent processing needed for existing detection techniques (e.g., VC imaging). Furthermore, such immediate (e.g., inline) detection of defects disclosed herein also improves the disposition of upstream process and tool marginalities for efficient variation control of the line, thereby reducing the overall yield loss and improving the quality and reliability of resulting integrated circuits. Disclosed systems, apparatus, articles of manufacture, and methods are accordingly directed to one or more improvement(s) in the operation of a machine such as a computer or other electronic and/or mechanical device and/or one or more improvements in semiconductor devices.

Further examples and combinations thereof include the following:
Example 1 includes an apparatus comprising interface circuitry, machine readable instructions, and programmable circuitry to at least one of instantiate or execute the machine readable instructions to determine a first contrast to noise ratio (CNR) in a first image of a location on a semiconductor wafer, determine a second CNR in a second image of the location on the semiconductor wafer, and determine whether the location includes a buried defect based on the first CNR and the second CNR.
Example 2 includes the apparatus of example 1, wherein the first image is a first SEM image captured based on a first landing energy, and the second image is a second SEM image captured based on a second landing energy, the second landing energy different than the first landing energy.
Example 3 includes the apparatus of any one of examples 1 or 2, wherein the location corresponds to an epitaxial fill region associated with at least one of a source or a drain of a gate-all-around transistor.
Example 4 includes the apparatus of any one of examples 1-3, wherein the programmable circuitry is to determine the location is completely missing epitaxial fill in response to the second CNR satisfying a first threshold.
Example 5 includes the apparatus of example 4, wherein the programmable circuitry is to determine the location includes the buried defect in response to the second CNR satisfying a second threshold and not satisfying the first threshold, an absolute value of the second threshold lower than an absolute value of the first threshold.
Example 6 includes the apparatus of example 5, wherein the programmable circuitry is to determine the location also includes a top defect in response to the first CNR satisfying a third threshold.
Example 7 includes the apparatus of example 5, wherein the programmable circuitry is to determine the location does not include a top defect in response to the first CNR not satisfying a third threshold.
Example 8 includes the apparatus of example 5, wherein the programmable circuitry is to determine the location is associated with a non-visible defect, when the second CNR does not satisfy the second threshold, in response to the first CNR not satisfying a third threshold.
Example 9 includes a non-transitory machine readable storage medium comprising instructions to cause programmable circuitry to at least determine a first contrast to noise ratio (CNR) in a first image of a location on a semiconductor wafer, determine a second CNR in a second image of the location on the semiconductor wafer, and determine whether the location includes a buried defect based on the first CNR and the second CNR.
Example 10 includes the machine readable storage medium of example 9, wherein the first image is a first SEM image captured based on a first landing energy, and the second image is a second SEM image captured based on a second landing energy, the second landing energy different than the first landing energy.
Example 11 includes the machine readable storage medium of example 9, wherein the instructions are to cause the programmable circuitry to determine the location is devoid of epitaxial fill in response to the second CNR satisfying a first threshold.
Example 12 includes the machine readable storage medium of example 11, wherein the instructions are to cause the programmable circuitry to determine the location includes the buried defect in response to the second CNR satisfying a second threshold and not satisfying the first threshold, an absolute value of the second threshold lower than an absolute value of the first threshold.
Example 13 includes the machine readable storage medium of example 12, wherein the instructions are to cause the programmable circuitry to determine the location also includes a top defect in response to the first CNR satisfying a third threshold.
Example 14 includes the machine readable storage medium of example 12, wherein the instructions are to cause the programmable circuitry to determine the location is associated with a non-visible defect, when the second CNR does not satisfy the second threshold, in response to the first CNR not satisfying a third threshold.
Example 15 includes a method comprising determining a first contrast to noise ratio (CNR) in a first image of a location on a semiconductor wafer, determining a second CNR in a second image of the location on the semiconductor wafer, and determining, based on instructions executed by programmable circuitry, whether the location includes a buried defect based on the first CNR and the second CNR.
Example 16 includes the method of example 15, further including determining the location is completely missing epitaxial fill in response to the second CNR satisfying a first threshold.
Example 17 includes the method of example 16, further including determining the location includes the buried defect in response to the second CNR satisfying a second threshold and not satisfying the first threshold, an absolute value of the second threshold lower than an absolute value of the first threshold.
Example 18 includes the method of example 17, further including determining the location also includes a top defect in response to the first CNR satisfying a third threshold.
Example 19 includes the method of example 17, further including determining the location includes the buried defect, when the second CNR does not satisfy the second threshold, in response to the first CNR not satisfying a third threshold and the second CNR satisfying.
Example 20 includes the method of any one of examples 15-19, wherein the determining of whether the location includes a buried defect is implemented after an epitaxial growth process and before a metal layer has been added to provide electrical routing for the gate-all-around transistor.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus comprising:
interface circuitry;
machine readable instructions; and
programmable circuitry to at least one of instantiate or execute the machine readable instructions to:
determine a first contrast to noise ratio (CNR) in a first image of a location on a semiconductor wafer;
determine a second CNR in a second image of the location on the semiconductor wafer; and
determine whether the location includes a buried defect based on the first CNR and the second CNR.

2. The apparatus of claim 1, wherein the first image is a first SEM image captured based on a first landing energy, and the second image is a second SEM image captured based on a second landing energy, the second landing energy different than the first landing energy.

3. The apparatus of any one of claims 1 or 2, wherein the location corresponds to an epitaxial fill region associated with at least one of a source or a drain of a gate-all-around transistor.

4. The apparatus of any one of claims 1-3, wherein the programmable circuitry is to determine the location is completely missing epitaxial fill in response to the second CNR satisfying a first threshold.

5. The apparatus of claim 4, wherein the programmable circuitry is to determine the location includes the buried defect in response to the second CNR satisfying a second threshold and not satisfying the first threshold, an absolute value of the second threshold lower than an absolute value of the first threshold.

6. The apparatus of claim 5, wherein the programmable circuitry is to determine the location also includes a top defect in response to the first CNR satisfying a third threshold.

7. The apparatus of claim 5, wherein the programmable circuitry is to determine the location does not include a top defect in response to the first CNR not satisfying a third threshold.

8. The apparatus of claim 5, wherein the programmable circuitry is to determine the location is associated with a non-visible defect, when the second CNR does not satisfy the second threshold, in response to the first CNR not satisfying a third threshold.

9. A method comprising:
determining a first contrast to noise ratio (CNR) in a first image of a location on a semiconductor wafer, the location associated with a gate-all-around transistor;
determining a second CNR in a second image of the location on the semiconductor wafer; and
determining whether the location includes a buried defect based on the first CNR and the second CNR.

10. The method of claim 9, further including determining the location is completely missing epitaxial fill in response to the second CNR satisfying a first threshold.

11. The method of claim 10, further including determining the location includes the buried defect in response to the second CNR satisfying a second threshold and not satisfying the first threshold, an absolute value of the second threshold lower than an absolute value of the first threshold.

12. The method of claim 11, further including determining the location also includes a top defect in response to the first CNR satisfying a third threshold.

13. The method of claim 11, further including determining the location includes the buried defect, when the second CNR does not satisfy the second threshold, in response to the first CNR not satisfying a third threshold and the second CNR satisfying.

14. The method of any one of claims 9-13, wherein the determining of whether the location includes a buried defect is implemented after an epitaxial growth process and before a metal layer has been added to provide electrical routing for the gate-all-around transistor.

15. Machine-readable storage including machine-readable instructions, when executed, to implement a method or realize an apparatus as claimed in any preceding claim.
